(19) Europäisches Patentamt
European Patent Office
Office européen des brevets

(11) **EP 2 216 809 A1**

(12) **DEMANDE DE BREVET EUROPEEN**

(43) Date de publication:
**11.08.2010 Bulletin 2010/32**

(51) Int Cl.:
***H01L 21/66*** *(2006.01)*

(21) Numéro de dépôt: **10152006.2**

(22) Date de dépôt: **28.01.2010**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**
Etats d'extension désignés:
**AL BA RS**

(30) Priorité: **05.02.2009 FR 0950698**

(71) Demandeur: **COMMISSARIAT A L'ENERGIE ATOMIQUE**
**75015 Paris (FR)**

(72) Inventeurs:
• **Milesi, Frédéric**
  **38360, Sassenage (FR)**
• **Mazen, Frédéric**
  **38100, Grenoble (FR)**

(74) Mandataire: **Lebkiri, Alexandre**
  **Cabinet Camus Lebkiri**
  **10 rue de la Pépinière**
  **75008 Paris (FR)**

(54) **Méthode de caracterisation d'un procédé d'implantation ionique.**

(57) La présente invention concerne une méthode de caractérisation d'un procédé d'implantation ionique. La méthode selon l'invention comporte une première étape de réalisation d'une jonction P/N dégradée (5) par l'implantation ionique d'espèces (4), ladite implantation d'espèces étant obtenue par le procédé d'implantation ionique à caractériser. La méthode selon l'invention comporte en outre une seconde étape de mesure d'un paramètre représentatif de la conduction électrique de ladite jonction P/N dégradée (5) et de la dispersion du paramètre sur la surface sur laquelle est réalisée la jonction P/N dégradée (5), le paramètre et la dispersion formant un paramètre et une dispersion de référence. Les première et seconde étapes sont répétées dans le temps de façon à suivre l'évolution du paramètre représentatif de la conduction électrique par rapport au paramètre de référence et de la dispersion du paramètre représentatif par rapport à la dispersion de référence.

**Fig. 1e**

**Description**

La présente invention concerne une méthode de caractérisation d'un procédé d'implantation ionique.

De façon générale, la fabrication de circuits intégrés repose sur divers procédés technologiques tels que la diffusion d'impuretés, la croissance par épitaxie, la gravure, l'oxydation et l'implantation ionique.

Le procédé d'implantation ionique consiste à introduire des atomes ionisés projectiles avec suffisamment d'énergie pour pénétrer à une certaine profondeur dans un échantillon cible (typiquement une plaquette semiconductrice) afin de modifier les caractéristiques électriques, physiques, chimiques ou optiques du matériau formant la cible.

L'implantation ionique est réalisée au moyen d'une machine à implantation ionique généralement composée :

- d'une partie génératrice d'ions à partir d'une source solide, liquide ou gazeuse dans un plasma excité (typiquement entre 10 et 100 kV) ;
- d'une partie de sélection des ions par un champ magnétique effectuant le tri par le rapport masse sur charge ;
- d'une partie accélératrice et décélératrice des ions à une énergie d'implantation souhaitée ;
- d'une partie de mise en forme du faisceau d'ions par des lentilles électrostatiques ou électromagnétiques ;
- d'un dispositif de balayage en x et en y afin d'implanter les ions de façon uniforme dans les plaquettes.

L'application la plus connue des procédés d'implantation ionique consiste à introduire dans des plaquettes (« wafer » en anglais) semi-conductrices (par exemple du silicium monocristallin), par bombardement ionique, des agents de dopage ou espèces dopantes comme le bore, le phosphore, l'arsenic ou le $BF_2$ dans le silicium ou l'azote, l'aluminium dans le carbure de silicium Ces agents de dopage modifient les propriétés électriques du semi-conducteur et permettent de réaliser des zones dopées de type P ou N. On notera que le bombardement d'un matériau semiconducteur cristallin par des atomes dopants crée des dommages dans la structure cristalline implantée. Il y a donc nécessité de restituer la cristallinité du matériau ; ceci est réalisé par un recuit thermique. Ce recuit thermique permet aussi une redistribution des atomes dopants et donc une modification du profil de dopage par phénomène de diffusion. Notons par ailleurs que ce recuit permet aussi l'activation électrique des atomes dopants implantés par leur passage en site substitutionnel.

L'augmentation de la densité d'intégration et des cadences de fabrication des circuits intégrés est allée de pair avec la nécessité d'un contrôle de plus en plus rigoureux des procédés d'implantation ionique. Ainsi, le souci premier des fabricants de circuits intégrés est de détecter rapidement les anomalies et dérives pouvant apparaître dans les machines d'implantation, pour éviter de gaspiller des plaquettes semi-conductrices. En effet, un retard de quelques heures dans la constatation d'une anomalie peut entraîner la perte de plusieurs dizaines voire plusieurs centaines de plaquettes de silicium, ce qui représente un surcoût considérable.

En pratique, les paramètres essentiels à contrôler d'un procédé d'implantation ionique sont l'énergie incidente des ions, exprimée en keV, et la dose $\phi$, exprimée en ions/cm². L'énergie détermine la profondeur de pénétration des ions. La dose $\phi$ est le nombre d'ions par unité de surface reçus par une plaquette implantée. La dose dépend de la durée du cycle d'implantation et du flux ionique, qui peut être réglé par une mesure du courant ionique : l'intégration du courant pour une surface bien définie sur la durée d'implantation permet de mesurer la dose.

Bien que les machines d'implantation soient équipées de divers appareillages et instruments de contrôle, l'expérience montre que le bon réglage des paramètres énergie et dose n'est réellement vérifiable qu'avec une analyse du résultat obtenu. Ainsi, on a développé diverses méthodes de contrôle permettant de mesurer les caractéristiques des zones dopées et de corriger si nécessaire les réglages initiaux.

La caractérisation d'un procédé d'implantation ionique consiste à suivre la valeur absolue d'une mesure caractéristique d'un même procédé au cours du temps (on parle de reproductibilité du procédé) ainsi que la dispersion de cette mesure sur plusieurs points de la plaque (on parle d'uniformité d'implantation). On entend par « même procédé » un procédé d'implantation d'une espèce déterminée avec une énergie déterminée dans un matériau donné, avec une dose bien définie et des conditions données de tilt, de twist, de rotation et de température du matériau durant l'implantation. La reproductibilité de la mesure doit rester dans une certaine gamme et l'uniformité doit être inférieure à une certaine valeur. La gamme et l'uniformité sont prédéfinies par les personnes responsables des machines d'implantation ionique et des procédés d'implantation.

On connait un certain nombre de techniques permettant de caractériser les procédés d'implantation ionique.

Une première technique connue consiste à mesure la résistance carrée, par exemple au moyen d'une sonde à quatre pointes métalliques ou d'une méthode SPV (Surface Photo Voltage). Une telle technique est décrite dans le document « Measurements of sheet resistivity with the four-point probe » (F.M. Smits BSTJ - 1958 - p371). C'est une technique en ligne de production, en plusieurs points de la plaque, non-destructive et rapide (environ 1 min pour réaliser la mesure). Pour mémoire, la méthode des quatre pointes utilise deux pointes qui servent à l'amenée du courant, les deux autres servant de prise de potentiel.

Cette technique nécessite toutefois d'effectuer après l'implantation à caractériser un recuit thermique de la plaquette afin de fixer les espèces présentes dans le substrat.

Une fois que la plaquette a subi le traitement thermique, on l'analyse en de nombreux points par un analyseur de résistance à quatre pointes fournissant de façon classique une indication de la résistance carrée de la zone étudiée.

Cette méthode de caractérisation de l'implantation par mesure de la résistance carrée présente par ailleurs une limitation importante puisqu'elle permet uniquement de caractériser l'implantation d'espèces dopantes. Elle n'est ainsi pas adaptée à la caractérisation de procédé d'implantation d'espèces non dopantes (par exemple des espèces légères telles que l'hydrogène ou l'hélium). Or, l'évolution des composants électroniques et des matériaux a entraîné l'utilisation de procédés d'implantation ionique pour des applications autres que la réalisation de zones dopées, notamment avec des espèces implantés qui ne sont pas des espèces dopantes. On peut citer à titre d'exemple l'implantation :

- d'hydrogène ou d'hélium dans le cas de procédés de transfert de couche, par exemple le procédé SMARTCUT™ pour la fabrication de matériau silicium sur isolant ou SOI (« Silicon On Insulator » en anglais) ;
- de germanium ou de silicium pour pré-amorphiser un matériau semi-conducteur tel que le silicium ou le germanium ;
- d'oxygène pour le procédé SIMOX (« Separation by Implantation of OXygen » en anglais);
- de carbone, de fluor ou d'azote pour réduire l'effet de diffusion des dopants lors du recuit.

Une solution connue permettant de caractériser des procédés d'implantation sans nécessité de recuit thermique (implantation ionique dite « as implanted » en anglais) et pour tout d'espèces (i.e. non nécessairement dopantes) consiste à utiliser la technique dénommée de spectroscopie SIMS (« Secondary Ion Mass Spectrometry » en anglais). Une telle technique décrite dans le document « Secondary Ion Mass Spectrometry : Basic concepts, instrumental aspects, applications, and trends » (A. Benninghoven, F.G. Rüdenauer, H.W. Werner - Wiley-Intersciences - 1987) consiste à analyser les zones implantées par spectrométrie de masse.

Cette méthode n'est cependant pas exempte d'inconvénients.

Ainsi, cette méthode nécessite l'abrasion préalable des parties à analyser et est par conséquent destructive.

Il s'agit par ailleurs d'une technique hors ligne de production, réalisée en un seul point de la plaque.

Elle nécessite en outre un certain délai de réalisation (1 jour environ) et une expertise dans la réalisation et l'analyse des mesures. Cette lenteur de mise en oeuvre (liée tant à la réalisation qu'à l'analyse) entraîne donc un coût élevé.

Une autre méthode, connue sous la dénomination « d'onde thermique » ou THERMAWAVE™, consiste à analyser la température d'une zone implantée excitée par un faisceau laser. On trouvera une description de cette méthode dans le document « Ion implant monitoring with thermal wave technology » (W. Lee Smith and al. - Appl. Phys. Lett. 47(6) - 1985 - p584). C'est une technique en ligne de production, non destructive, rapide (environ 1 min) et en plusieurs points de la plaque.

Cette méthode présente également certains inconvénients.

Ainsi, les résultats obtenus sont des valeurs sans dimensions qu'il faut corréler avec d'autres résultats pour maitriser l'évolution de la valeur.

En outre, cette méthode nécessite un appareillage complexe et coûteux et ne fait pas l'objet d'un consensus général quant à son caractère non destructif, certains considérant que l'échauffement des zones testées provoque un recuit du silicium.

Dans ce contexte, la présente invention a pour but de fournir une méthode de caractérisation d'un procédé d'implantation ionique sans recuit (i.e. « as implanted ») permettant la caractérisation de tout type d'espèces du tableau de Mendeleïev implantées, en particulier non dopantes, ladite méthode étant susceptible d'être mise en oeuvre en ligne de production, en plusieurs points de la plaque, et étant par ailleurs non-destructrice, rapide et peu couteuse.

A cette fin, l'invention propose une méthode de caractérisation d'un procédé d'implantation ionique **caractérisée en ce qu'**elle comporte :

- une première étape de réalisation d'une jonction P/N dégradée par l'implantation ionique d'espèces, ladite implantation d'espèces étant obtenue par ledit procédé d'implantation ionique à caractériser ;
- une seconde étape de mesure d'un paramètre représentatif de la conduction électrique de ladite jonction P/N dégradée et de la dispersion dudit paramètre sur la surface sur laquelle est réalisée ladite jonction P/N dégradée, ledit paramètre et ladite dispersion formant un paramètre et une dispersion de référence ;

  lesdites première et seconde étapes étant répétées dans le temps de façon à suivre l'évolution du paramètre représentatif de la conduction électrique par rapport au dit paramètre de référence et de la dispersion du paramètre représentatif par rapport à ladite dispersion de référence.

Grâce à l'invention, on utilise avantageusement une jonction P/N volontairement dégradée par le procédé d'implantation que l'on cherche à caractériser. On entend par « jonction P/N dégradée » une jonction P/N dont la conduction électrique est réduite par rapport à une jonction P/N obtenue dans les mêmes conditions que la jonction P/N dégradée mais sans implantation ionique d'espèces par le procédé d'implantation ionique à caractériser

On notera que la méthode selon l'invention ne nécessite pas de recuit après l'implantation (i.e. il s'agit bien d'une implantation « as implanted »).

La méthode selon l'invention permet de caractériser toutes les espèces du tableau de Mendeleïev et leurs molécules associées, y-compris les espèces non dopantes, quels que soient l'énergie, la dose, le tilt, le twist, le nombre de rotation et la température du substrat d'implantation dans tous les matériaux semi-conducteurs. La caractérisation se fera par la mesure et le suivi dans le temps d'un paramètre représentatif de la conduction électrique de la jonction P/N dégradée tel que sa résistance carrée, sa résistivité ou sa mobilité. La méthode est par ailleurs rapide, elle peut être mise en oeuvre en ligne de production et en tout point de la plaque sur la jonction P/N est réalisée.

La méthode selon l'invention n'introduit aucun surcoût par rapport aux équipements déjà présents dans les salles blanches du secteur de la microélectronique puisqu'il est possible d'utiliser, pour la mesure du paramètre représentatif de la conduction électrique de la jonction P/N dégradée, des outils de caractérisation classiques de l'implantation ionique tels que une sonde de mesure quatre pointes ou un appareil SPV (« Surface Photo Voltage » en anglais).

La méthode selon l'invention peut également présenter une ou plusieurs des caractéristiques ci-dessous, considérées individuellement ou selon toutes les combinaisons techniquement possibles :

- ledit paramètre représentatif de la conduction électrique est la résistance carrée ;
- la profondeur moyenne d'implantation d'espèces est sensiblement égale à la profondeur de ladite jonction P/N dégradée ;
- la concentration d'espèces implantées selon ledit procédé d'implantation ionique à caractériser est strictement inférieure à la concentration de dopants aptes à réaliser le dopage P ou N dans la zone d'implantation ;
- le substrat sur lequel est réalisé ladite jonction P/N est un substrat de type N ;
- les dopants aptes à réaliser le dopage P dans la zone d'implantation sont des atomes de bore ;
- ladite étape de réalisation d'une jonction P/N dégradée comporte les étapes suivantes :

  ○ réalisation d'une jonction P/N non dégradée puis;
  ○ implantation d'espèces obtenue par ledit procédé d'implantation ionique à caractériser dans ladite jonction P/N non dégradée ;

- la réalisation de ladite jonction P/N non dégradée est obtenue par l'un des procédés suivants :

  ○ implantation ionique, dans un substrat dopé selon un premier type de dopage P ou N, de dopants aptes à réaliser un second type de dopage inverse dudit premier type de dopage puis recuit thermique pour activer les atomes dopants implantés ;
  ○ dépôt par épitaxie, sur un substrat dopé selon un premier type de dopage P ou N, d'une couche dopée selon un second type de dopage inverse dudit premier type de dopage;
  ○ diffusion, dans un substrat dopé selon un premier type de dopage P ou N, d'atomes dopants selon un second type de dopage inverse dudit premier type de dopage;

- la méthode de caractérisation selon l'invention comporte une étape de mesure d'un paramètre représentatif de la conduction électrique de ladite jonction P/N non dégradée identique au dit paramètre représentatif de la conduction électrique de ladite jonction P/N dégradée ;
- ladite étape de réalisation d'une jonction P/N dégradée comporte les étapes suivantes :

  ○ implantation ionique, dans un substrat dopé selon un premier type de dopage P ou N, de dopants aptes à réaliser un second type de dopage inverse dudit premier type de dopage puis ;
  ○ implantation ionique desdites espèces selon ledit procédé d'implantation ionique à caractériser puis ;
  ○ recuit thermique pour activer les atomes dopants implantés ;

- ladite étape de réalisation d'une jonction P/N dégradée comporte les étapes suivantes :

  ○ implantation ionique, dans un substrat dopé selon un premier type de dopage P ou N, desdites espèces selon ledit procédé d'implantation ionique à caractériser puis ;
  ○ implantation ionique de défauts aptes à réaliser un second type de dopage inverse dudit premier type de dopage puis ;
  ○ recuit thermique pour activer les atomes dopants implantés.

D'autres caractéristiques et avantages de l'invention ressortiront clairement de la description qui en est donnée ci-dessous, à titre indicatif et nullement limitatif, en référence aux figures annexées, parmi lesquelles :

- les figures 1 a à 1 e illustrent les étapes d'un premier mode de réalisation de la méthode de caractérisation selon l'invention;
- les figures 2 a à 2 e illustrent les étapes d'un second mode de réalisation de la méthode de caractérisation selon l'invention;

- les figures 3 a à 3 e illustrent les étapes d'un troisième mode de réalisation de la méthode de caractérisation selon l'invention ;

- les figures 4 à 6 illustrent une mise en oeuvre pratique de la méthode de caractérisation selon l'invention.

Dans toutes les figures, les éléments communs portent les mêmes numéros de référence.

La finalité de la méthode selon l'invention est de caractériser un procédé d'implantation ionique. Les ions incidents implantés vont perdre leur énergie par chocs successifs avec les atomes du réseau cristallin. Après choc, les projectiles prennent des directions distribuées statistiquement suivant toutes les directions. De façon logique, l'énergie perdue reste statistiquement plus faible que l'énergie totale et l'ion continue à progresser dans sa direction d'implantation malgré une déviation de la trajectoire. En fin de course, lorsque l'énergie cinétique est très amoindrie, les ions se retrouvent confinés dans un espace restreint en raison de fortes liaisons entre atomes. Ceci explique d'une part, la dispersion des trajectoires et d'autre part, que l'on définisse statistiquement une profondeur moyenne de pénétration $Rp_{caract}$. En première approximation, le profil statistique de la concentration $N(x)$ d'espèces implantées en fonction de la profondeur $x$ d'implantation est un profil gaussien donné par la formule suivante :

$$N(x) = C_{caract} . exp\left(\frac{(x - Rp_{caract})^2}{2\Delta Rp_{caract}^2}\right),$$

où $Rp_{caract}$ est la profondeur moyenne de pénétration, $\Delta Rp_{caract}$ est l'écart type et $C_{caract}$ est la concentration maximale à la profondeur moyenne de pénétration.

Outre le type d'espèces, l'énergie et la dose, un procédé d'implantation est également défini par les paramètres de tilt, de twist, le nombre de rotation de la plaquette, la température de la plaquette d'implantation et le matériau dans lequel on va implanter. Le tilt correspond à l'angle entre le faisceau d'ions incidents et la normale à la surface de la plaquette à implanter et le twist correspond à l'angle de rotation de la plaquette dans son plan.

Ainsi, à un procédé d'implantation donné à caractériser (espèces, énergie, dose, tilt, twist, nombre de rotation, température du substrat d'implantation données et matériau dans lequel on va implanter) correspond une profondeur moyenne de pénétration $Rp_{caract}$ et une concentration maximale à la profondeur moyenne de pénétration $C_{caract}$.

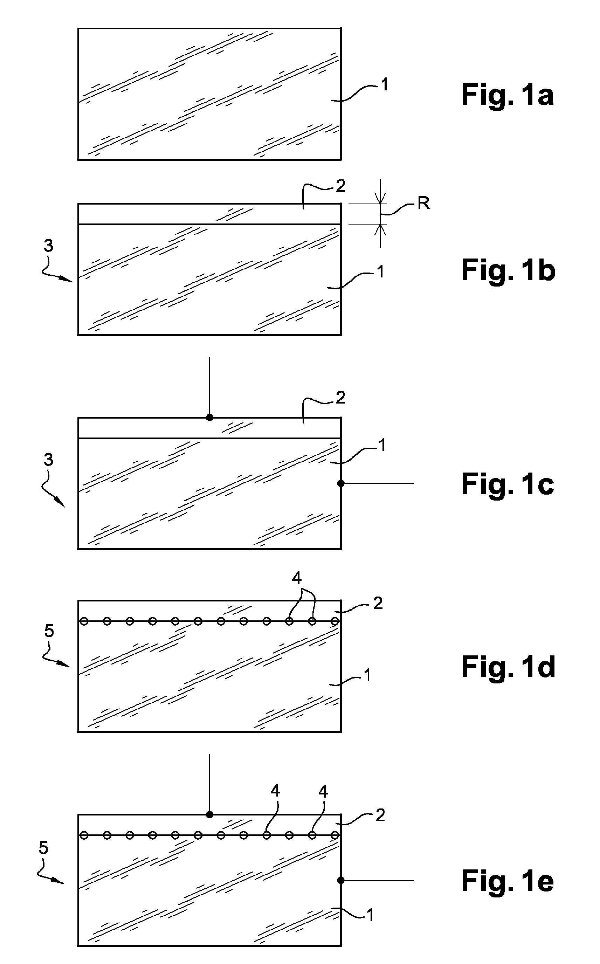

Les figures 1 a à 1 e illustrent les étapes d'un premier mode de réalisation de la méthode de caractérisation selon l'invention

La figure 1 a montre que l'on part d'une plaquette (« wafer ») 1 formant un substrat vierge. Ce substrat est réalisé dans un matériau semi-conducteur, avantageusement de type N, par exemple un substrat de silicium de type N.

La figure 1b illustre la réalisation, à partir de la plaquette 1 dopée N d'une zone 2 dopée P de sorte que l'on forme une jonction P/N.

Comme nous l'avons mentionné plus haut, le procédé d'implantation que l'on cherche à caractériser est notamment défini par une profondeur moyenne de pénétration $Rp_{caract}$ et une concentration maximale à la profondeur moyenne de pénétration $C_{caract}$.

Selon un mode de réalisation particulièrement avantageux, pour caractériser ce procédé, il est préférable que la concentration maximale à la profondeur moyenne de pénétration $C_{caract}$ soit strictement inférieure à la concentration $C_{jonction}$ des dopants de type P de la zone 2 : $C_{caract} < C_{jonction}$. Nous désignerons par condition 1 cette première condition.

En outre, avantageusement, il est également préférable que la profondeur moyenne de pénétration $Rp_{caract}$ soit sensiblement égale à la profondeur R de la jonction électrique. Nous désignerons par condition 2 cette deuxième condition. On entend par « profondeur de la jonction électrique » l'épaisseur de la zone 2 dopée P.

La zone 2 dopée P peut par exemple être réalisée par implantation ionique d'espèces dopantes de type P (par exemple des éléments de la colonne III de la classification de Mendeleïev tels que le bore B, le galium Ga ou l'indium In dans un matériau semiconducteur de la colonne IV tel que le silicium Si). Selon un mode de réalisation préférentiel, pour des questions de limitations physiques des machines d'implantation, le bore est ici utilisé en tant que dopant de type P pour la réalisation de zone 2. Comme nous l'avons déjà mentionné plus haut, la sensibilité de la méthode de caractérisation selon l'invention est meilleure si la profondeur moyenne d'implantation d'espèces à caractériser $Rp_{caract}$ est sensiblement égale à la profondeur R de la jonction électrique. La profondeur moyenne d'implantation est fonction de l'énergie d'implantation et de la masse de l'espèce implantée. Plus un atome est lourd, plus il faut d'énergie pour l'implanter profondément. Les machines à implantation ionique sont limitées physiquement en tension d'accélération (typiquement 250kV). Afin de pouvoir caractériser tous les procédés d'implantation, il est donc avantageux de réaliser l'implantation de la jonction électrique P/N avec l'élément dopant le plus léger (i.e. Bore). Comme le bore est un élément de dopage de type P, il sera donc plus avantageux de réaliser l'implantation de dopant P sur un substrat de type N, pour réaliser la jonction P/N.

Dans le cas d'une réalisation de la zone 2 par implantation ionique, il est alors possible, à l'aide de logiciels de simulation informatique (par exemple les logiciels SRIM ou Crystal-TRIM), de déterminer par dichotomie, la profondeur moyenne de pénétration $Rp_{jonction}$ correspondant à l'implantation des espèces dopantes de type P de sorte que cette profondeur moyenne de pénétration $Rp_{jonction}$ soit sensiblement égale à la profondeur moyenne de pénétration $Rp_{caract}$ du procédé d'implantation à caractériser (respect de la condition 1 mentionnée ci-dessus avec R= $Rp_{jonction}$). Une fois la profondeur moyenne de pénétration $Rp_{jonction}$ déterminée, ce même logiciel de simulation permet de définir la dose d'implantation d'espèces dopantes de type P afin que la concentration maximale $C_{jonction}$ (correspondant à la profondeur moyenne de pénétration $Rp_{jonction}$) soit supérieure à la concentration maximale $C_{caract}$ du procédé d'implantation à caractériser.

Une fois l'implantation réalisée, II convient de restituer la cristallinité du matériau ; ceci est réalisé par un recuit thermique. Ce recuit thermique permet aussi une redistribution des atomes dopants et donc une modification du profil de dopage par phénomène de diffusion. Notons par ailleurs que ce recuit permet aussi l'activation électrique des atomes dopants implantés par leur passage en site substitutionnel.

On notera que la zone 2 dopée P peut également être obtenue par d'autres techniques :

Ainsi, la zone 2 dopée P peut être réalisé par épitaxie ; en d'autres termes, on fait croitre une couche dopée P (formant la zone 2) sur le substrat 1. Les trois grandes catégories d'épitaxie peuvent être utilisées à cet effet :

- épitaxie par jet moléculaire ou MBE (« Molecular Beam Epitaxy » en anglais) ;
- épitaxie en phase liquide ou LPE (« Liquid Phase Epitaxy ») ;
- épitaxie en phase vapeur ou CVD (« Chemical Vapor Deposition »).

La zone 2 dopée P peut également être réalisée via un procédé de diffusion ; pour ce faire, on met en contact le substrat 1 avec des atomes dopants de type P qui vont être activés par chauffage. Trois grands types de source peuvent être utilisés pour fournir les éléments dopants que l'on souhaite faire pénétrer dans les substrats : les sources gazeuses, liquides ou solides.

Bien entendu, que la zone 2 dopée P soit obtenue par épitaxie ou par diffusion, il est également préférable que les conditions 1 et 2 soient respectées.

A ce stade de la méthode selon l'invention, nous sommes donc en présence d'une jonction P/N 3.

On notera que, même si l'invention s'applique préférentiellement en réalisant la jonction P/N en implantant des dopants P (typiquement du Bore) dans un substrat de type N, la méthode selon l'invention s'applique également en inversant les dopages P et N en partant d'un substrat de type P et en réalisant une zone N par l'un des procédés décrits ci-dessus. Dans ce cas, on utilisera des éléments de la colonne V (Phosphore, Arsenic, Antimoine, etc...) pour réaliser le dopage de type N dans un substrat Silicium de type P.

La figure 1c illustre une étape de mesure d'un paramètre représentatif de la conduction électrique de la jonction P/N 3. Ce paramètre représentatif est préférentiellement la résistance carrée avec la dispersion de ladite résistance sur la surface de la plaque. La résistance carrée, exprimée en Ohm par carré, et sa dispersion peuvent être par exemple obtenues, de façon connue, par une méthode 4 pointes ou par une méthode SPV (« Surface Photo Voltage »). On notera qu'il est également possible de mesurer, à la place de la résistance carrée, la résistivité (exprimée en Ohm.cm et obtenue par une méthode 4 pointes ou par une méthode SPV) ou la mobilité (exprimée en $cm^2/V.s$ et obtenue par exemple par une technique d'effet Hall) de la jonction 3.

Afin d'obtenir la meilleure interprétation possible des résultats obtenus par la méthode selon l'invention, il est préférable que la jonction P/N 3 soit réalisée avec une bonne uniformité sur la plaque 1 de base. On entend par « bonne uniformité » une dispersion de la résistance carrée, de la résistivité ou de la mobilité qui doit être la plus faible possible.

La figure 1d illustre une étape d'implantation d'espèces 4 dans la zone 2 dopée P de la jonction P/N 3 telle que représentées en figures 1b et 1 c. Cette implantation est réalisée par le procédé d'implantation ionique que l'on cherche à caractériser. L'implantation va entraîner une dégradation électrique de la zone 2 : le bombardement des espèces implantées au sein de la zone 2 en matériau semiconducteur cristallin va induire des dommages dans la structure cristalline et un déplacement des atomes dopants de type P, certains passant d'un site substitutionnel à un site interstitiel ; cette implantation permet donc de réaliser une jonction P/N dégradée 5 en termes de conduction électrique par rapport à la jonction P/N 3 initiale. En conséquence, l'implantation réalisée par le procédé à caractériser implique de fait une augmentation de la résistance carrée, de la résistivité ou de la mobilité de la jonction P/N dégradée 5 par rapport à la résistance carrée, la résistivité ou la mobilité de la jonction P/N initiale 3. On notera plus généralement que l'étape d'implantation d'espèces 4 peut être réalisée n'importe où dans la jonction P/N 3 non dégradée (i.e. dans la zone 2 dopée P de la jonction P/N, dans la zone 1 dopée N ou à cheval sur les zones 1 et 2 dopées respectivement N et P).

La figure 1e illustre à ce titre une étape de mesure, pour la jonction P/N dégradée 5, du même paramètre représentatif de la conduction électrique que celui mesuré pour la jonction P/N initiale 3 (figure 1 c). Ce paramètre représentatif est préférentiellement la résistance carrée avec la dispersion de ladite résistance sur la surface de la plaque. Cette mesure permet d'obtenir une valeur de référence (ainsi que la dispersion de cette valeur sur la plaque) de la jonction P/N dégradée 5.

Typiquement, on crée une pluralité de plaquettes avec des jonctions P/N initiales 3 réalisées dans des conditions semblables (figure 1 a à figure 1 c). A l'instant de référence, on dégrade (figure 1 d) l'une de ces plaquettes par le procédé d'implantation que l'on cherche à caractériser. On réalise ensuite une mesure (figure 1 e) de la résistance carrée de cette première plaquette ainsi que sa dispersion. Cette mesure constitue donc la valeur de référence de la jonction P/N dégradée 5 (la dispersion de cette valeur sur la plaquette est également une valeur de référence). On notera que la méthode de caractérisation selon l'invention s'applique à tout type d'espèces implantées et non exclusivement aux espèces dopantes.

L'objectif étant de caractériser le procédé d'implantation, on réitère l'étape de dégradation et de mesure sur une autre plaquette à un instant postérieur à l'instant de référence (typiquement 1 jour ou 1 semaine plus tard selon la fréquence de caractérisation du procédé d'implantation à caractériser). La nouvelle mesure de la résistance carrée et de la dispersion sur de la jonction P/N dégradée permet de suivre l'évolution dans le temps de la résistance carrée et de sa dispersion par rapport à la résistance carrée et la dispersion de référence. La reproductibilité de la mesure doit rester dans une certaine gamme et l'uniformité doit être inférieure à une certaine valeur. Un écart trop important par rapport aux valeurs de référence indique un problème de réglage d'un des paramètres d'implantation du procédé à caractériser.

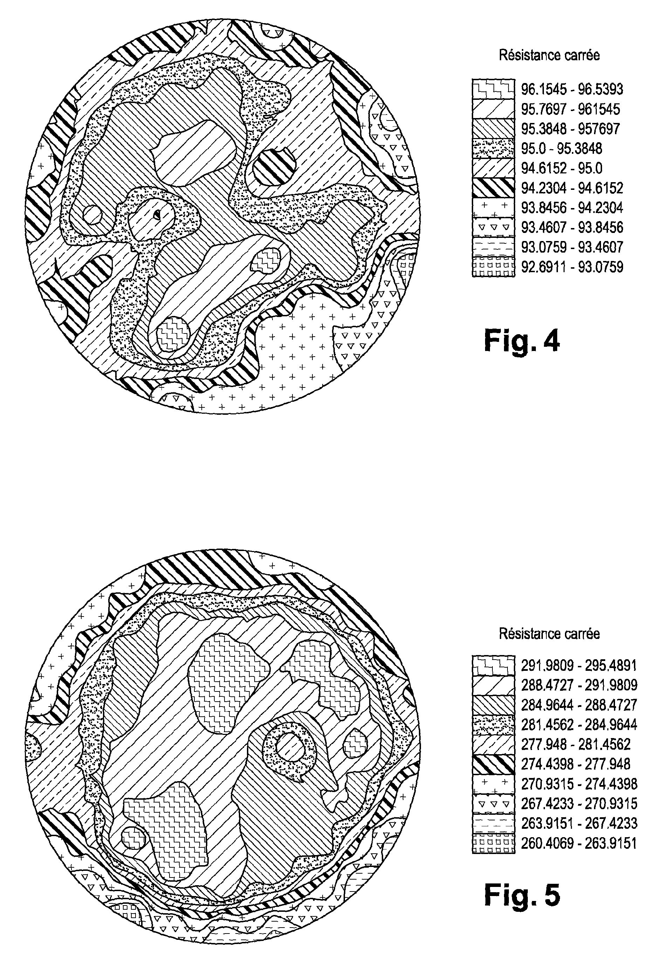

Les figures 4 à 6 illustrent ce phénomène par une mise en oeuvre pratique de la méthode de caractérisation selon l'invention. On cherche dans ce cas à caractériser un procédé d'implantation d'ions H$^+$ (espèce non dopante dans le silicium) à une énergie de 90keV et une dose de 10$^{15}$ at.cm$^{-2}$. L'utilisation d'un logiciel de simulation informatique de type SRIM ou Crystal-TRIM donne une profondeur moyenne de pénétration Rp$_{caract}$ du procédé d'implantation à caractériser environ égale 800 nm et une concentration maximale C$_{caract}$ correspondant à la profondeur moyenne de pénétration environ égale à 5.10$^{20}$ at.cm$^{-3}$.

La figure 4 représente une cartographie de la résistance carrée sur une plaquette comportant une jonction P/N initiale telle que la jonction P/N 3 représentée en figure 1 b. La cartographie représente différentes zones de la plaquette correspondant à différents intervalles de valeurs de résistance carrée exprimée en ohm/carré. Cette jonction P/N est réalisée par implantation de bore dans un substrat de silicium dopé N suivi d'un recuit d'activation des dopants. Toujours au moyen d'un logiciel de type SRIM ou Crystal-TRIM, on détermine par dichotomie, la profondeur moyenne de pénétration Rp$_{jonction}$ correspondant à l'implantation du bore de sorte que cette profondeur moyenne de pénétration Rp$_{jonction}$ soit sensiblement égale à la profondeur moyenne de pénétration Rp$_{caract}$ (i.e. pour obtenir une valeur de Rp$_{jonction}$ sensiblement égale à 800 nm). On obtient pour ce faire une valeur d'énergie d'implantation du bore environ égale à 250 keV. Une fois l'énergie d'implantation déterminée, ce même logiciel de simulation permet de définir la dose d'implantation d'espèces dopantes de type P afin que la concentration maximale C$_{jonction}$ (correspondant à la profondeur moyenne de pénétration Rp$_{jonction}$) soit supérieure à la concentration maximale C$_{caract}$ du procédé d'implantation à caractériser. Typiquement, pour avoir une concentration de bore maximale C$_{jonction}$ (correspondant à la profondeur moyenne de pénétration Rp$_{jonction}$ de 800 nm) de l'ordre de 5.10$^{21}$ at.cm$^{-3}$ (soit un facteur 10 par rapport à la concentration C$_{caract}$), on utilise une dose d'implantation de 10$^{16}$ at.cm$^{-2}$ pour du bore à 250 keV.

La jonction P/N initiale ainsi réalisée a une résistance carrée moyenne de 95 ohm/carré avec une dispersion sur plaquette de 0,91 %.

La figure 5 représente une cartographie de la résistance carrée sur une plaquette comportant une jonction P/N dégradée par rapport à la jonction P/N dont la cartographie est représentée en figure 4. La plaquette dégradée est obtenue par le procédé d'implantation à caractériser (donc par implantation d'ions H$^+$ à une énergie de 90keV et une dose de 10$^{15}$ at.cm$^{-2}$).

La jonction P/N ainsi dégradée passe à une valeur de résistance carrée moyenne égale à 280 ohm/carré avec une dispersion sur plaquette de 3,72% : ces valeurs constituent les valeurs de référence dont on va suivre l'évolution dans le temps. On observe bien entendu une augmentation de la résistance carrée et de la dispersion de cette jonction P/N dégradée par rapport à la jonction P/N initiale.

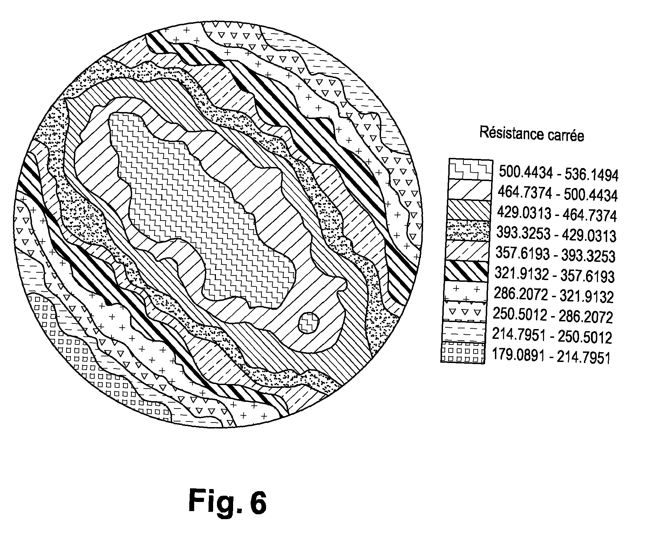

La figure 6 représente une cartographie de la résistance carrée sur une plaquette comportant une jonction P/N dégradée par rapport à la jonction P/N dont la cartographie est représentée en figure 4. La plaquette dégradée est obtenue par le procédé d'implantation à caractériser (donc par implantation d'ions H$^+$ à une énergie de 90keV et une dose de 10$^{15}$ at.cm$^{-2}$). Les conditions expérimentales d'obtention de cette jonction dégradée sont identiques à celles utilisées pour la réalisation de jonction P/N décrite en référence à la figure 5 à l'exception du balayage horizontal du faisceau d'ions de la plaquette modifié de façon à rendre non uniforme l'implantation.

La jonction P/N ainsi dégradée passe à une valeur de résistance carrée moyenne égale à 364 ohm/carré avec une dispersion sur plaquette de 29,47%. On constate donc une augmentation sensible de la dispersion mesurée par rapport à la dispersion de référence égale à 3,72%. Ainsi, une modification d'un paramètre de réglage tel que le balayage est détectée immédiatement par une variation substantielle par rapport aux valeurs de référence.

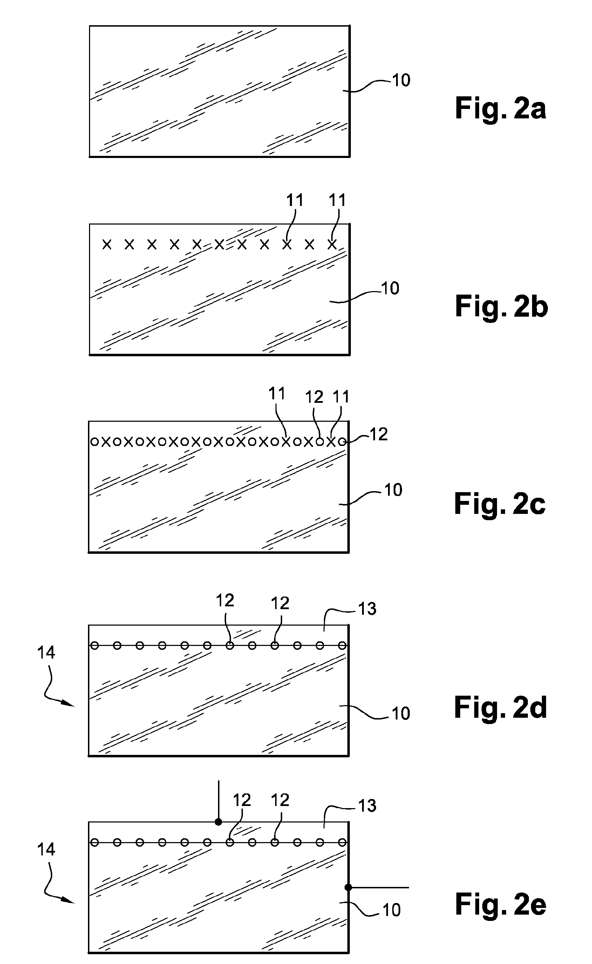

Les figures 2 a à 2 e illustrent les étapes d'un second mode de réalisation de la méthode de caractérisation selon l'invention.

La figure 2 a montre que l'on part d'une plaquette (« wafer ») 10 formant un substrat vierge. Ce substrat est réalisé dans un matériau semi-conducteur avantageusement de type N, par exemple un substrat de silicium de type N.

La figure 2b illustre la réalisation, à partir de la plaquette 10 dopée N d'une implantation de dopants 11 aptes à former un dopage P (typiquement une implantation de B, de Ga ou d'In dans le silicium).

Comme nous l'avons mentionné plus haut, le procédé d'implantation que l'on cherche à caractériser est notamment défini par une profondeur moyenne de pénétration $Rp_{caract}$ et une concentration maximale à la profondeur moyenne de pénétration $C_{caract}$.

Au moyen de logiciels de simulation informatique de type SRIM ou Crystal-TRIM, on détermine par dichotomie la profondeur moyenne de pénétration $Rp_{jonction}$ correspondant à l'implantation des espèces aptes à réaliser le dopage de type P de sorte que cette profondeur moyenne de pénétration $Rp_{jonction}$ soit sensiblement égale à la profondeur moyenne de pénétration $Rp_{caract}$ du procédé d'implantation à caractériser (respect de la condition 1 décrite plus haut). Une fois la profondeur moyenne de pénétration $Rp_{jonction}$ déterminée, ce même logiciel de simulation permet de définir la dose d'implantation d'espèces aptes à réaliser le dopage de type P afin que la concentration maximale $C_{jonction}$ (correspondant à la profondeur moyenne de pénétration $Rp_{jonction}$) soit supérieure à la concentration maximale $C_{caract}$ du procédé d'implantation à caractériser.

On notera que la méthode selon l'invention s'applique tout autant en inversant les dopages P et N en partant d'un substrat de type P et en réalisant une zone implantés par des dopants aptes à réaliser un dopage N.

La figure 2c illustre une étape d'implantation d'espèces 12 dans la zone déjà implantée par les dopants 11. Cette implantation est réalisée par le procédé d'implantation ionique que l'on cherche à caractériser.

Une fois cette double implantation réalisée (figure 2b et 2c), il convient de restituer la cristallinité du matériau ; ceci est réalisé par un recuit thermique illustrée en figure 2 e. Ce recuit thermique permet aussi une redistribution des atomes dopants implantés lors de l'étape illustrée en figure 2b et donc une modification du profil de dopage par phénomène de diffusion. Notons par ailleurs que ce recuit permet aussi l'activation électrique des atomes dopants implantés par leur passage en site substitutionnel. Grâce à ce recuit, on obtient une zone 13 de type P. Cette zone 13 est toutefois dégradée par la présence des espèces 12 implantées qui réduisent les possibilités de mise en site substitutionnel des dopants 11 (qui reste en site interstitiel) réalisant le dopage P. On notera que, contrairement au premier mode de réalisation décrit en référence aux figures 1 a à 1 e, on obtient ici une jonction P/N dégradée 14 sans passer par la réalisation d'une jonction P/N initiale ; ceci est du au fait que l'on réalise la double implantation avant le recuit activant les espèces dopantes. Cette jonction P/N 14 reste toutefois une jonction P/N dégradée par rapport à une même jonction P/N obtenue sans implantation d'espèces par le procédé à caractériser. Ce phénomène de dégradation implique de fait une augmentation de la résistance carrée, de la résistivité ou de la mobilité de la jonction P/N dégradée 14 par rapport à la résistance carrée, la résistivité ou la mobilité d'une jonction P/N obtenue sans implantation des espèces par le procédé à caractériser.

La figure 2e illustre une étape de mesure, pour la jonction P/N dégradée 14, d'un paramètre représentatif de la conduction électrique (typiquement la résistance carrée avec la dispersion de ladite résistance sur la surface de la plaque). Cette mesure permet d'obtenir une valeur de référence (ainsi que la dispersion de cette valeur sur la plaque) de la jonction P/N dégradée 14.

Typiquement, on crée une pluralité de plaquettes implantées par des espèces 11 réalisées dans des conditions semblables (figure 2 a et figure 2b). A l'instant de référence, on réalise une jonction P/N dégradée (figure 2c et figure 2d) sur l'une de ces plaquettes par le procédé d'implantation que l'on cherche à caractériser suivi d'un recuit. On réalise ensuite une mesure (figure 2 e) de la résistance carrée de cette première plaquette ainsi que sa dispersion. Cette mesure constitue donc la valeur de référence de la jonction P/N dégradée 14 (la dispersion de cette valeur sur la plaquette est également une valeur de référence). On notera que la méthode de caractérisation selon l'invention s'applique à tout type d'espèces implantées et non exclusivement aux espèces dopantes.

L'objectif étant de caractériser le procédé d'implantation, on réitère l'étape de dégradation et de mesure sur une autre plaquette à un instant postérieur à l'instant de référence (typiquement 1 jour ou 1 semaine plus tard selon la fréquence de caractérisation du procédé d'implantation à caractériser). La nouvelle mesure de la résistance carrée et de la dispersion sur de la jonction P/N dégradée permet de suivre l'évolution dans le temps de la résistance carrée et de sa dispersion par rapport à la résistance carrée et la dispersion de référence. Un écart trop important par rapport aux valeurs de référence indiquerait un problème de réglage d'un des paramètres d'implantation du procédé à caractériser.

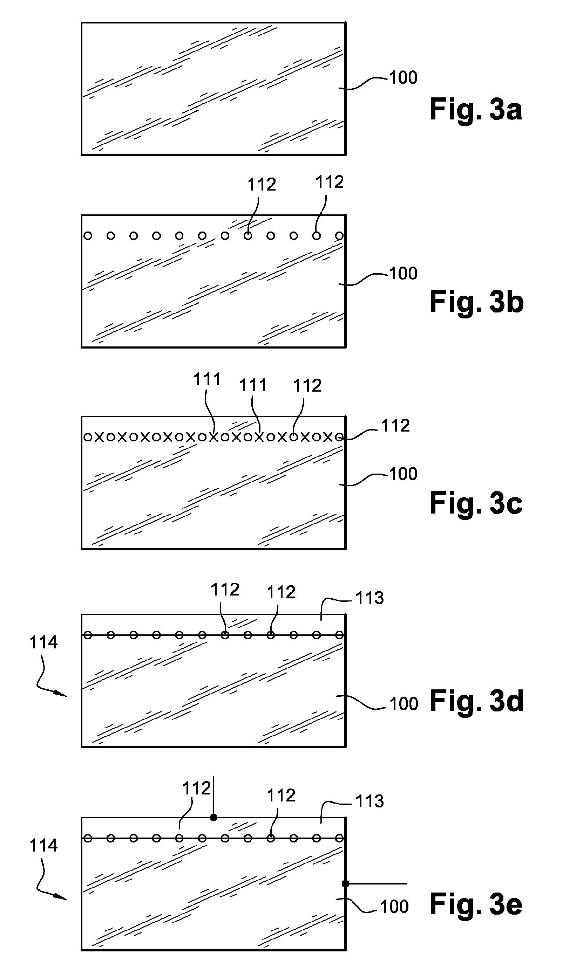

Les figures 3 a à 3 e illustrent les étapes d'un troisième mode de réalisation de la méthode de caractérisation selon l'invention. Ce troisième mode de réalisation est très proche du second mode de réalisation illustré en référence aux figures 2 a à 2 e, la seule différence consistant à inverser les deux étapes d'implantations.

La figure 3 a montre que l'on part d'une plaquette (« wafer ») 100 formant un substrat vierge. Ce substrat est réalisé dans un matériau semi-conducteur avantageusement de type N, par exemple un substrat de silicium de type N.

La figure 3b illustre une étape d'implantation d'espèces 112 dans le substrat 100. Cette implantation est réalisée par le procédé d'implantation ionique que l'on cherche à caractériser.

La figure 3c illustre la réalisation d'une implantation de dopants 111 aptes à former un dopage P (typiquement une implantation de B, de Ga ou d'In dans le silicium), l'implantation étant réalisée dans la zone implantée par espèces 112.

Comme nous l'avons mentionné plus haut, le procédé d'implantation que l'on cherche à caractériser est notamment défini par une profondeur moyenne de pénétration $Rp_{caract}$ et une concentration maximale à la profondeur moyenne de pénétration $C_{caract}$.

Au moyen de logiciels de simulation informatique de type SRIM ou Crystal-TRIM, on détermine par dichotomie la profondeur moyenne de pénétration $Rp_{jonction}$ correspondant à l'implantation des espèces aptes à réaliser le dopage de type P de sorte que cette profondeur moyenne de pénétration $Rp_{jonction}$ soit sensiblement égale à la profondeur moyenne de pénétration $Rp_{caract}$ du procédé d'implantation à caractériser (respect de la condition 1 décrite plus haut). Une fois la profondeur moyenne de pénétration $Rp_{jonction}$ déterminée, ce même logiciel de simulation permet de définir la dose d'implantation d'espèces aptes à réaliser le dopage de type P afin que la concentration maximale $C_{jonction}$ (correspondant à la profondeur moyenne de pénétration $Rp_{jonction}$) soit supérieure à la concentration maximale $C_{caract}$ du procédé d'implantation à caractériser.

On notera que la méthode selon l'invention s'applique tout autant en inversant les dopages P et N en partant d'un substrat de type P et en réalisant une zone implantés par des dopants aptes à réaliser un dopage N.

Une fois cette double implantation réalisée (figures 3b et 3c), il convient de restituer la cristallinité du matériau ; ceci est réalisé par un recuit thermique illustrée en figure 3 e. Ce recuit thermique permet aussi une redistribution des atomes dopants implantés lors de l'étape illustrée en figure 3c et donc une modification du profil de dopage par phénomène de diffusion. Notons par ailleurs que ce recuit permet aussi l'activation électrique des atomes dopants implantés par leur passage en site substitutionnel. Grâce à ce recuit, on obtient une zone 113 de type P. Cette zone 113 est toutefois dégradée de par la présence des espèces 112 implantées qui réduisent les possibilités de mise en site substitutionnel des dopants 111 (qui reste en site interstitiel) réalisant le dopage P. On notera que, contrairement au premier mode de réalisation décrit en référence aux figures 1 a à 1 e, on obtient ici une jonction P/N dégradée 114 sans passer par la réalisation d'une jonction P/N initiale ; ceci est du au fait que l'on réalise la double implantation avant le recuit activant les espèces dopantes. Cette jonction P/N 114 reste toutefois une jonction P/N dégradée par rapport à une même jonction P/N obtenue sans implantation d'espèces par le procédé à caractériser. Ce phénomène de dégradation implique de fait une augmentation de la résistance carrée, de la résistivité ou de la mobilité de la jonction P/N dégradée 114 par rapport à la résistance carrée, la résistivité ou la mobilité d'une jonction P/N obtenue sans implantation des espèces par le procédé à caractériser.

La figure 3e illustre une étape de mesure, pour la jonction P/N dégradée 114, d'un paramètre représentatif de la conduction électrique (typiquement la résistance carrée avec la dispersion de ladite résistance sur la surface de la plaque). Cette mesure permet d'obtenir une valeur de référence (ainsi que la dispersion de cette valeur sur la plaque) de la jonction P/N dégradée 114.

Typiquement, on part d'une pluralité de plaquettes vierges (figure 3a). A l'instant de référence, on réalise une jonction P/N dégradée (figure 3b à figure 3d) sur l'une de ces plaquettes par le procédé d'implantation que l'on cherche à caractériser suivi de l'implantation des espèces dopantes suivi d'un recuit. On réalise ensuite une mesure (figure 3 e) de la résistance carrée de cette première plaquette ainsi que sa dispersion. Cette mesure constitue donc la valeur de référence de la jonction P/N dégradée 114 (la dispersion de cette valeur sur la plaquette est également une valeur de référence). On notera que la méthode de caractérisation selon l'invention s'applique à tout type d'espèces implantées et non exclusivement aux espèces dopantes.

L'objectif étant de caractériser le procédé d'implantation, on réitère l'étape de dégradation et de mesure sur une autre plaquette à un instant postérieur à l'instant de référence (typiquement 1 jour ou 1 semaine plus tard selon la fréquence de caractérisation du procédé d'implantation à caractériser). La nouvelle mesure de la résistance carrée et de la dispersion sur de la jonction P/N dégradée permet de suivre l'évolution dans le temps de la résistance carrée et de sa dispersion par rapport à la résistance carrée et la dispersion de référence. Un écart trop important par rapport aux valeurs de référence indiquerait un problème de réglage d'un des paramètres d'implantation du procédé à caractériser.

De façon générale, quel que soit le mode de réalisation, la résistance carrée, exprimée en Ohm par carré, et sa dispersion peuvent être par exemple obtenues, de façon connue, par une méthode 4 pointes telle que décrite dans le document « « Measurements of sheet resistivity with the four-point probe » (F.M. Smits BSTJ - 1958 - p371) ou par une méthode SPV (« Surface Photo Voltage ») également appelée JPV (« Junction Photo Voltage« ) telle que décrite par exemple dans le document «Characterization of ultras-hallow junctions using frequency-dependent junction photovoltage and its lateral attenuation » (Applied Physics Letters 89, 151123 (2006)).

La méthode selon invention permet de caractériser tous les procédés d'implantation ionique « as-implanted » (le recuit utilisé dans les modes de réalisation décrits plus haut ne l'est que pour la réalisation de la jonction P/N dans le cas de la réalisation de la zone P ou N par implantation), quels que soient les espèces implantées, les paramètres d'implantation (espèce, énergie, dose, tilt, twist, rotation et température du matériau durant l'implant) et le matériau semi-conducteur.

Afin de connaître la sensibilité des paramètres d'implantation, il est utile de réaliser pour chaque procédé d'implantation des abaques en faisant varier le paramètre à étudier de +10% et de -10% par rapport au procédé de d'implantation de référence (i.e. que l'on cherche à caractériser). Ce faisant, on peut déterminer si un écart de la résistance carrée et/ou de sa dispersion par rapport à la résistance carrée ou la dispersion de référence est significatif d'un problème de réglage ; ce type d'abaque peut par ailleurs permettre d'identifier le paramètre qui cause le problème de réglage en fonction de la valeur de l'écart.

Bien entendu, le dispositif et le procédé selon l'invention ne sont pas limités aux modes de réalisation qui viennent d'être décrits à titre indicatif et nullement limitatif en référence aux figures 1 à 6.

Notamment, même si l'invention a été plus particulièrement décrite dans le cas d'une mesure de résistance carrée, on notera qu'il est également possible de mesurer, à la place de la résistance carrée, la résistivité (exprimée en Ohm.cm et qui peut également être obtenue par une méthode 4 pointes ou par une méthode SPV) ou la mobilité (exprimée en $cm^2/V.s$ et qui peut par exemple être obtenue par exemple par une technique d'effet Hall).

**Revendications**

1. Méthode de caractérisation d'un procédé d'implantation ionique **caractérisée en ce qu'**elle comporte :

   - une première étape de réalisation d'une jonction P/N dégradée (5, 14, 114) par l'implantation ionique d'espèces (4, 12, 112), ladite implantation d'espèces étant obtenue par ledit procédé d'implantation ionique à caractériser ;
   - une seconde étape de mesure d'un paramètre représentatif de la conduction électrique de ladite jonction P/N dégradée (5, 14, 114) et de la dispersion dudit paramètre sur la surface sur laquelle est réalisée ladite jonction P/N dégradée (5, 14, 114), ledit paramètre et ladite dispersion formant un paramètre et une dispersion de référence ;
   lesdites première et seconde étapes étant répétées dans le temps de façon à suivre l'évolution du paramètre représentatif de la conduction électrique par rapport au dit paramètre de référence et de la dispersion du paramètre représentatif par rapport à ladite dispersion de référence.

2. Méthode de caractérisation selon la revendication 1 **caractérisée en ce** ledit paramètre représentatif de la conduction électrique est donné par la résistance carrée.

3. Méthode de caractérisation selon l'une des revendications précédentes **caractérisée en ce que** la profondeur moyenne d'implantation d'espèces est sensiblement égale à la profondeur de ladite jonction P/N dégradée.

4. Méthode de caractérisation selon l'une des revendications précédentes **caractérisée en ce que** la concentration d'espèces implantées selon ledit procédé d'implantation ionique à caractériser est strictement inférieure à la concentration de dopants aptes à réaliser le dopage P ou N dans la zone d'implantation.

5. Méthode de caractérisation selon l'une des revendications précédentes **caractérisée en ce que** le substrat (1, 10, 100) sur lequel est réalisé ladite jonction P/N est un substrat de type N.

6. Méthode de caractérisation selon la revendication 5 **caractérisée en ce que** les dopants (11, 111) aptes à réaliser le dopage P dans la zone d'implantation sont des atomes de bore.

7. Méthode de caractérisation selon l'une des revendications précédentes **caractérisée en ce que** ladite étape de réalisation d'une jonction P/N dégradée (5) comporte les étapes suivantes :

   - réalisation d'une jonction P/N non dégradée (3) puis;
   - implantation d'espèces (4) obtenue par ledit procédé d'implantation ionique à caractériser dans ladite jonction P/N non dégradée (3).

8. Méthode de caractérisation selon la revendication 7 **caractérisée en ce que** la réalisation de ladite jonction P/N non dégradée (3) est obtenue par l'un des procédés suivants :

   - implantation ionique, dans un substrat (1) dopé selon un premier type de dopage P ou N, de dopants aptes à réaliser un second type de dopage inverse dudit premier type de dopage puis recuit thermique pour activer les atomes dopants implantés ;
   - dépôt par épitaxie, sur un substrat (1) dopé selon un premier type de dopage P ou N, d'une couche dopée selon un second type de dopage inverse dudit premier type de dopage;
   - diffusion, dans un substrat dopé (1) selon un premier type de dopage P ou N, d'atomes dopants selon un second type de dopage inverse dudit premier type de dopage.

9. Méthode de caractérisation selon l'une des revendications 7 ou 8 **caractérisée en ce qu'**elle comporte une étape de mesure d'un paramètre représentatif de la conduction électrique de ladite jonction P/N non dégradée (3) identique au dit paramètre représentatif de la conduction électrique de ladite jonction P/N dégradée (5).

**10.** Méthode de caractérisation selon l'une des revendications 1 à 6 **caractérisée en ce que** ladite étape de réalisation d'une jonction P/N dégradée (14) comporte les étapes suivantes :

- implantation ionique, dans un substrat (10) dopé selon un premier type de dopage P ou N, de dopants (11) aptes à réaliser un second type de dopage inverse dudit premier type de dopage puis ;
- implantation ionique desdites espèces (12) selon ledit procédé d'implantation ionique à caractériser puis ;
- recuit thermique pour activer les atomes dopants implantés.

**11.** Méthode de caractérisation selon l'une des revendications 1 à 6 **caractérisée en ce que** ladite étape de réalisation d'une jonction P/N dégradée (114) comporte les étapes suivantes :

- implantation ionique, dans un substrat (100) dopé selon un premier type de dopage P ou N, desdites espèces (112) selon ledit procédé d'implantation ionique à caractériser puis ;
- implantation ionique de dopants (111) aptes à réaliser un second type de dopage inverse dudit premier type de dopage puis ;
- recuit thermique pour activer les atomes dopants implantés.

**12.** Méthode de caractérisation selon l'une des revendications précédentes **caractérisée en ce que** lesdites espèces implantées selon ledit procédé d'implantation ionique à caractériser sont des espèces non dopantes.

Fig. 1a

Fig. 1b

Fig. 1c

Fig. 1d

Fig. 1e

**Fig. 2a**

**Fig. 2b**

**Fig. 2c**

**Fig. 2d**

**Fig. 2e**

100

**Fig. 3a**

112    112

100

**Fig. 3b**

111   111   112

112

100

**Fig. 3c**

112   112   113

114

100   **Fig. 3d**

112   112   113

114

100   **Fig. 3e**

Résistance carrée

| | |
|---|---|
| | 96.1545 - 96.5393 |
| | 95.7697 - 961545 |
| | 95.3848 - 957697 |
| | 95.0 - 95.3848 |
| | 94.6152 - 95.0 |
| | 94.2304 - 94.6152 |
| + + | 93.8456 - 94.2304 |
| ▽ ▽ ▽ | 93.4607 - 93.8456 |
| | 93.0759 - 93.4607 |
| | 92.6911 - 93.0759 |

**Fig. 4**

Résistance carrée

| | |
|---|---|
| | 291.9809 - 295.4891 |
| | 288.4727 - 291.9809 |
| | 284.9644 - 288.4727 |
| | 281.4562 - 284.9644 |
| | 277.948 - 281.4562 |
| | 274.4398 - 277.948 |
| + + | 270.9315 - 274.4398 |
| ▽ ▽ ▽ | 267.4233 - 270.9315 |
| | 263.9151 - 267.4233 |
| | 260.4069 - 263.9151 |

**Fig. 5**

Résistance carrée

500.4434 - 536.1494
464.7374 - 500.4434
429.0313 - 464.7374
393.3253 - 429.0313
357.6193 - 393.3253
321.9132 - 357.6193
286.2072 - 321.9132
250.5012 - 286.2072
214.7951 - 250.5012
179.0891 - 214.7951

Fig. 6

Europäisches
Patentamt

European
Patent Office

Office européen
des brevets

**RAPPORT DE RECHERCHE EUROPEENNE**

Numéro de la demande

EP 10 15 2006

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2006/189008 A1 (KISHIRO KOICHI [JP]) 24 août 2006 (2006-08-24) * page 6, alinéa 65 - page 12, alinéa 135; revendications 1-9; figures 3-12 * ----- | 1-12 | INV. H01L21/66 |
| X | US 2008/006886 A1 (MEHTA NARENDRA S [US] ET AL) 10 janvier 2008 (2008-01-10) | 1,10-12 | |
| A | * page 1, alinéa 17 - page 4, alinéa 47; revendications 1-16; figures 1-8 * ----- | 2-9 | |
| A | US 2007/249073 A1 (HILLARD ROBERT J [US]) 25 octobre 2007 (2007-10-25) * abrégé; revendication 1; figures 1-4 * ----- | 1-12 | |

DOMAINES TECHNIQUES
RECHERCHES (IPC)

H01L

Le présent rapport a été établi pour toutes les revendications

| Lieu de la recherche | Date d'achèvement de la recherche | Examinateur |
|---|---|---|
| La Haye | 18 février 2010 | Hedouin, Mathias |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 ...............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 15 2006

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-02-2010

| Document brevet cité au rapport de recherche | Date de publication | Membre(s) de la famille de brevet(s) | Date de publication |
|---|---|---|---|
| US 2006189008 A1 | 24-08-2006 | JP 2006229145 A | 31-08-2006 |
| US 2008006886 A1 | 10-01-2008 | AUCUN | |
| US 2007249073 A1 | 25-10-2007 | EP 1863078 A2<br>JP 2007294980 A | 05-12-2007<br>08-11-2007 |

EPO FORM P0460

Pour tout renseignement concernant cette annexe : voir Journal Officiel de l'Office européen des brevets, No.12/82

**EP 2 216 809 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **F.M. Smits.** Measurements of sheet resistivity with the four-point probe. *BSTJ,* 1958, 371
- **A. Benninghoven ; F.G. Rüdenauer ; H.W. Werner.** Secondary Ion Mass Spectrometry : Basic concepts, instrumental aspects, applications, and trends. Wiley-Intersciences, 1987

- **W. Lee Smith.** Ion implant monitoring with thermal wave technology. *Appl. Phys. Lett.,* 1985, vol. 47 (6), 584
- Characterization of ultras-hallow junctions using frequency-dependent junction photovoltage and its lateral attenuation. *Applied Physics Letters,* 2006, vol. 89, 151123